# EUROPEAN PATENT SPECIFICATION

(11) **EP 0 332 327 B1**
(45) Date of publication and mention of the grant of the patent: **12.05.1993**
(21) Application number: 89301971.1
(22) Date of filing: 28.02.1989
(51) Int. Cl.: G12B 17/02, G01R 1/18, H05K 9/00

(54) **A sealing member**
Dichtungselement
Elément d'étanchéité

(30) Priority: 09.03.1988 GB 8805556
(43) Date of publication of application: 13.09.1989
(73) Proprietor: DOWTY SEALS LIMITED, Tewkesbury Gloucestershire GL20 8JS (GB)
(72) Inventor: Walker, Robin Anthony, Northway Tewkewsbury Glos. (GB)
(74) Representative: Hogg, Jeffery Keith

(56) References cited:
- EP-A- 0 083 723
- EP-A- 0 115 048
- DE-A- 3 008 264

## Description

This invention relates to sealing members and, in particular, sealing members for use in apparatus for the shielding of electronic equipment from electromagnetic interference [EMI] and radio frequency interference [RFI].

A large amount of modern electronics equipment operates with very low electrical signals, in order to maintain minimal heat generation characteristics in the circuitry. Therefore, the circuits and circuit boards of the equipment can be placed in very close proximity to one another, and consequentially a large amount of equipment can be housed in a relatively small space.

However, as a result of this, in particular the low electrical signals used in the circuits, the equipment is vulnerable/susceptible to interference, such as EMI or RFI which can induce false electrical signals.

EMI and RFI are of particular concern with regard to the electronic equipment used in a modern aircraft, in particular the navigation and guidance systems thereof, because it is possible that in certain circumstances this type of interference may cause a potentially dangerous or catastrophic failure of equipment. Examples of previous failures along this line include:
1. Aircraft crashing or becoming unstable in flight when flying over radio stations, or as a result thereof,
2. Aircraft systems being unintentionally activated,
   and
3. Systems breaking down or simply malfunctioning.

With conventional systems the electronic equipment is shielded from interference by a surrounding metal box. Further, due to the necessity to maintain and test the electronic equipment housed in the box, the box is provided with a number of doors/windows, each of which needs to be sealingly engaged with the box.

The sealing engagement of the box and the windows or doors with respect to one another means that a non conductive sealing member is provided about each of the windows and doors. This means that the shielding effect provided by the metal box will have a number of discontinuities, which will allow interference to break through the shielding and interfere with the operation of the electronic equipment housed within the box.

This shows how critical it is to ensure that the shielding provided should be maintained absolutely integral around the electronic equipment as a whole. Previously this has been achieved by providing a simple sealing member appropriatly positioned so as to ensure the electrical integrity of the shielding means as a whole. This simple solution has however encountered several problems which result from the fact that the material from which the sealing members are made is susceptible to breakdown/ degradation in certain environments. In particular environments which have a corrosive effect thereupon, for example, salt or salty air.

Therefore in order to ensure that the integral shielding of the electronic equipment is fully maintained, and to avoid total breakdown of the sealing member, the sealing members have to be replaced at regular intervals.

The breakdown/degradation of the material of the sealing member can cause a reduction in the conductive efficiency thereof, and hence the efficiency of the shielding provided.

The breakdown in the efficiency of the sealing member to shield the electrical/electronic equipment by its actual breakdown/degradation will result in RFI/EMI interference of the circuits of the equipment this in turn may lead to the earlier detailed consequences. Hence to maintain efficiency these sealing members must be replaced very regularly.

In addition to the physical human safety aspects involved, which can be very drastic, the required maintenance to the shielding of the electronic equipment can mean that expensive equipment is out of service because of this maintenance. This in turn because of:
(i) wasted time for the equipment i.e. the down time thereof;
(ii) the cost of replacement parts, for example the sealing members;
   and
(iii) the time involved in maintenance, and cost thereof;
can lead to high cost in time and labour.

The present invention is concerned with providing a sealing means which is not affected by the environment, and provides shielding apparatus with total electrical integrity.

In accordance with the present invention a sealing member is manufactured from elastomeric material, and is characterised in that it comprises:
- a corrosive resistant sealing element;
   and
- an electrical conductive shielding sealing element;
wherein the corrosive resistant sealing element and the electrical conductive shielding sealing element are formed as a single sealing member, so that the corrosive resistant sealing element protects the electrical conductive shielding sealing element from corrosive environments.

With a sealing member made in accordance with the present invention in place, and therefore in use, the corrosive environment is prevented from attacking the electrical conductive shielding sealing element. Hence, the electrical conductive shielding sealing element will not breakdown/degrade so readily, and the electrical integrity of the shielding apparatus can be maintained. The working life expectancy of a sealing member, made in accordance with the present invention is greater, by several whole lives, than that of the previously proposed sealing arrangements.

The sealing member may be used in shielding apparatus under a negative or positive pressure balance on the shielded apparatus.

Normally, the sealing member is formed so that in use the corrosive resistant sealing element is disposed in between the electrical conductive shielding sealing element and the corrosive environment.

The corrosive environment may comprise either the general atmosphere surrounding the shielded electronic equipment and/or the direct atmosphere in which the electronic circuitry is housed. As a consequence of this the sealing elements can be arranged to protect the electrical conductive shielding sealing element from either or both of these environments.

Therefore, in accordance with a second aspect of the invention a sealing member which is manufactured from elastomeric material and which comprises:
- two corrosive resistant sealing elements,
   and
- an electrical conductive shielding sealing element,
wherein the two corrosive resistant sealing elements and the electrical conductive shielding sealing element are formed as a single sealing member, so that the electrical conductive shielding sealing element is interdisposed between the two corrosive resistant sealing elements.

A sealing member made in accordance with the second aspect of the invention is suitable for use in situations where the environments on both sides of the sealing members are corrosive with regard to the material of the electrical conductive shielding sealing element.

Elastomeric materials suitable for use as corrosive resistant sealing elements have been developed over a period of several years. Any of the known materials may be used, this could be a simple straight forward elastomeric material, for example a silicon or epoxy based material. Alternatively, the elastomeric material can be loaded with a material suitable to provide, or enhance, the particular corrosion resistant properties, for example, resistance to corrosive attack by a particular chemical.

The elastomeric material from which the electrical conductive shielding sealing element is formed is, preferably, an elastomeric material loaded with a suitable conductive filler. However, may comprise any intrinsically conductive polymer, suitable for this purpose.

Conductive fillers, which render polymeric materials conductive have been known for a number of years, any of these conductive fillers may be used in accordance with the present invention. These conductive fillers include carbon black, metal powders (for example copper, aluminium, silver, nickel) and coated powders (for example silver coated nickel, silver coated copper etc.).

However, because of the characteristics required in the system, preferably the electrical conductive shielding sealing material is a base elastomeric material loaded with a metallic powder, and most preferably a silver containing metal powder. This is because these materials, in combination, provide the system with the best electrical conducting characteristics for the function of shielding.

Preferably, the base elastomeric material of the electrical conductive shielding sealing element is a silicon based or epoxy based material.

The elastomeric material of the corrosive resistant sealing element and the base elastomeric material of the electrical conductive shielding sealing element are normally selected so that there are no interactions therebetween, which if this was the case may lead to a breakdown of the sealing member.

Further, the elastomeric material of the corrosive resistant sealing element (or where the material includes a filler, the base elastomeric material) and the base elastomeric material of the electrical conductive shielding sealing elements may be the same elastomeric material. This, however, is not of great consequence providing there is no interaction therebetween.

The sealing member is preferably formed so that a section of the or each corrosive resistant sealing element overlaps the electrical conductive shielding sealing element. However, it is important that an electrical conductive path is provided through the sealing member in order to ensure electrical continuity in a shielding apparatus into which the sealing member is fitted.

The invention also includes a method of manufacturing a sealing member made in accordance with the first or second aspects of the invention.

Any type of seal or gasket forming technology may be used to manufacture sealing members in accordance with either the first or second aspects of the present invention. Preferably, sealing members made in accordance with the first or second aspect of the present invention are manufactured using a printing process.

The invention will now be described, by way of example, with reference to the accompanying drawings in which:

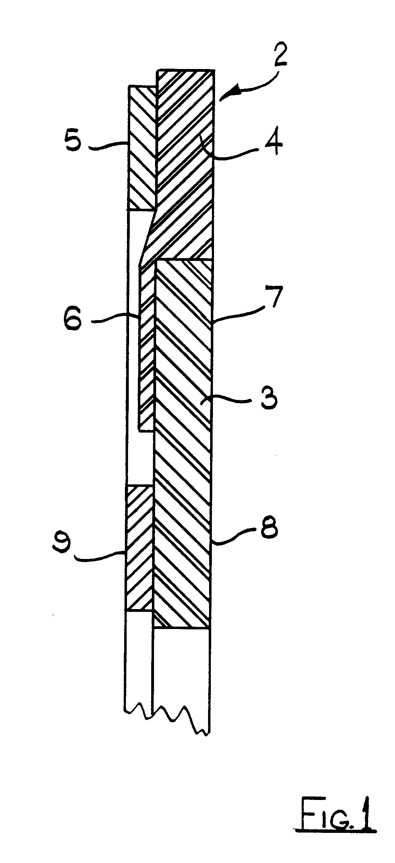

- Figure 1:: shows a cross-sectional view of a sealing member made in accordance with the invention;

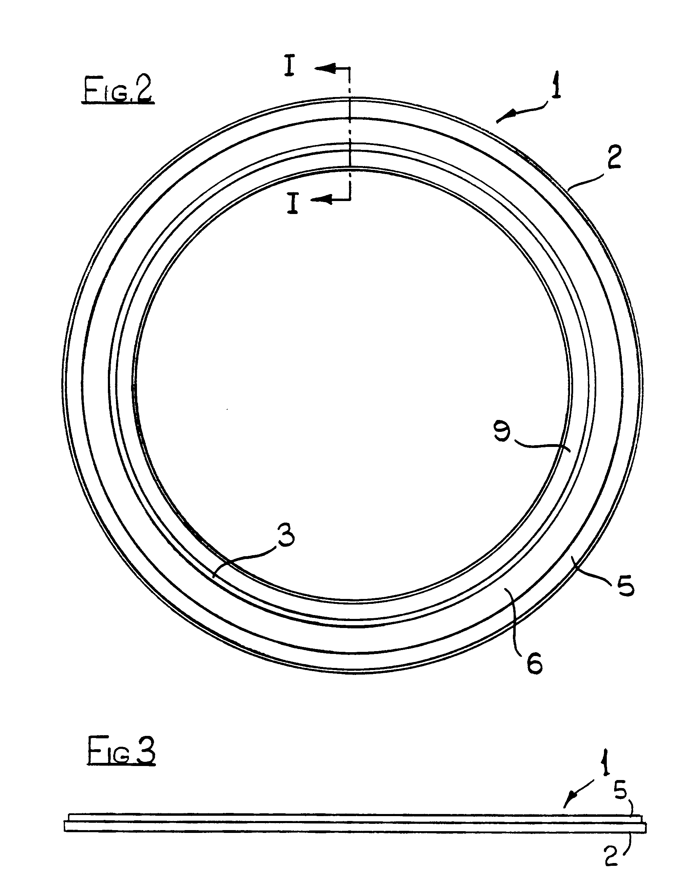

- Figure 2:: shows a plan view of the sealing member of Figure 1;
and
- Figure 3:: shows a side view of the sealing member of Figure 1.

Now referring to the drawings, a sealing member 1 comprises:
- a corrosive resistant elastomeric sealing element 2,
   and
- and electrical conductive shielding sealing element 3.

The corrosive resistant element 2 includes a base section 4, a sealing section 5, and an overlap 6. The overlap 6, overlies a section 7 of the electrical conductive shielding sealing element 3.

The electrical conductive shielding sealing element 3 includes a base section 8 and a sealing section 9.

The sealing members 1 are formed by a printing process, in which the corrosive resistant element 2 is printed from a silicon base elastomer and the conductive element 3 is printed from a silver loaded epoxy based elastomer.

The method employed comprises:
- printing the base section 8 of the conductive element 3;
- printing the base section of the corrosive resistant element 2 with the overlap 6, immediately adjacent to the base section 8 with the overlap 6 extending over a section 7 thereof;
- printing the sealing section 5 of the corrosive resistant element 2 in the appropriate position;
   and
- printing the sealing section 9 of the conductive element 3 on the base section 8.

The respective printed section may be cured or partially cured prior to the next printing operation.

The sealing member 1 shown in this example is circular in profile, this is not intended as a restriction to the invention. In fact the shape of the sealing member may be altered to fit the particular requirement encountered.

## Claims

1. A sealing member (1) manufactured from elastomeric material, is characterised in that it comprises:
- a corrosive resistant sealing element (2);
and
- an electrical conductive shielding sealing element (3);
wherein the corrosive resistant sealing element and the electrical conductive shielding sealing element are formed as a single sealing member, so that the corrosive resistant sealing element protects the electrical conductive shielding sealing element from corrosive environments.

2. A sealing member as claimed in claim 1, wherein the sealing member is formed so that in use the corrosive resistant sealing element is disposed inbetween the electrical conductive shielding sealing element and the corrosive environment.

3. A sealing member as claimed in claim 1 or 2, which comprises:
- two corrosive resistant sealing elements,
and
- an electrical conductive shielding sealing element,
wherein the two corrosive resistant sealing elements and the electrical conductive shielding sealing element are formed as a single sealing member, so that the electrical conductive shielding sealing element is interdisposed between the two corrosive resistant sealing elements.

4. A sealing member as claimed in any one of the preceding claims, in which the corrosive resistant sealing element is made from an elastomeric material loaded with a material suitable to provide, or enhance the particular corrosion resistant properties.

5. A sealing member as claimed in any one of claims 1 to 4, in which the elastomeric material from which the electrical conductive shielding sealing element is formed is an elastomeric material loaded with a conductive filler.

6. A sealing member as claimed in any one of the preceding claims, in which the electrical conductive shielding sealing material comprises a base elastomeric material loaded with a metallic powder.

7. A sealing member as claimed in claim 6, in which the base elastomeric material of the electrical conductive shielding sealing element is a silicon or epoxy based material.

8. A sealing member as claimed in any one of the preceding claims, in which the sealing member is formed so that a section of the or each corrosive resistant sealing element overlaps the electrical conductive shielding sealing element.

9. A method of manufacturing a sealing member as claimed in any one of the preceding claims which comprises printing the corrosive resistant sealing element (2) and the electrical conductive shielding sealing element (3).

## Patentansprüche

1. Dichtungsteil (1), das aus elastomerem Material hergestellt und dadurch gekennzeichnet ist, daß es aufweist:
- ein korrosionsbeständiges Dichtungselement (2);
und
- ein elektrisch leitendes abschirmendes Dichtungselement (3);
wobei das korrosionsbeständige Dichtungselement und das elektrisch leitende abschirmende Dichtungselement als gemeinsames Dichtungsteil ausgebildet sind, so daß das korrosionsbeständige Dichtungselement das elektrisch leitende abschirmende Dichtungselement gegen eine korrodierende Umgebung schützt.

2. Dichtungsteil nach Anspruch 1, bei dem das Dichtungsteil so ausgebildet ist, daß im Betrieb das korrosionsbeständige Dichtungselement zwischen dem elektrisch leitenden abschirmenden Dichtungselement und der korrodierenden Umgebung angeordnet ist.

3. Dichtungsteil nach Anspruch 1 oder 2, welches aufweist:
- zwei korrosionsbeständige Dichtungselemente,
und
- ein elektrisch leitendes abschirmendes Dichtungselement,
wobei die beiden korrosionsbeständigen Dichtungselemente und das elektrisch leitende abschirmende Dichtungselement als gemeinsames Dichtungsteil ausgebildet sind, so daß das elektrisch leitende abschirmende Dichtungselement zwischen den beiden korrosionsbeständigen Dichtungselementen angeordnet ist.

4. Dichtungsteil nach einem der vorhergehenden Ansprüche, bei dem das korrosionsbeständige Dichtungselement aus einem elastomeren Material besteht, das ein Material zum Erzeugen oder Verstärken der speziellen korrosionsbeständigen Eigenschaften enthält.

5. Dichtungsteil nach einem der Ansprüche 1 bis 4, bei dem das elastomere Material, aus dem das elektrisch leitende abschirmende Dichtungselement gebildet ist, ein elastomeres Material ist, das einen leitenden Füller enthält.

6. Dichtungsteil nach einem der vorhergehenden Ansprüche, bei dem das elektrisch leitende abschirmende Dichtungsmaterial aus einem elastomeren Grundmaterial besteht, das ein Metallpulver enthält.

7. Dichtungsteil nach Anspruch 6, bei dem das elastomere Grundmaterial des elektrisch leitenden abschirmenden Dichtungselementes ein Material auf Silizium- oder Epoxyd-Basis ist.

8. Dichtungsteil nach einem der vorhergehenden Ansprüche, bei dem das Dichtungsteil so ausgebildet ist, daß ein Abschnitt des oder jedes korrosionsbeständigen Dichtungselementes das elektrisch leitende abschirmende Dichtungselement überlappt.

9. Verfahren zum Herstellen eines Dichtungsteiles nach einem der vorhergehenden Ansprüche, das das Drucken des korrosionsbeständigen Dichtungselementes (2) und des elektrisch leitenden abschirmenden Dichtungselementes (3) umfaßt.

## Revendications

1. Un élément d'étanchéité (1) fabriqué à partir d'un matériau élastomère, caractérisé en ce qu'il comprend :
- un élément d'étanchéité (2) résistant à la corrosion ; et
- un élément d'étanchéité (3) de protection de conduction électrique ;
selon lequel l'élément d'étanchéité résistant à la corrosion et l'élément d'étanchéité, de protection de conduction électrique sont formés en un seul élément d'étanchéité, de sorte que l'élément d'étanchéité résistant à la corrosion protège l'élément d'étanchéité de protection de conduction électrique de l'environnement corrosif.

2. Un élément d'étanchéité selon la revendication 1, selon lequel l'élément d'étanchéité est formé de façon qu'à l'usage, l'élément d'étanchéité résistant à la corrosion est disposé entre l'élément d'étanchéité de protection de conduction électrique et l'environnement corrosif.

3. Un élément d'étanchéité selon la revendication 1 ou 2 qui comprend :
- deux éléments d'étanchéité résistant à la corrosion et
- un élément d'étanchéité de protection de conduction électrique,
selon lequel les deux éléments d'étanchéité résistant à la corrosion et l'élément d'étanchéité de protection de conduction électrique sont formés en un seul élément d'étanchéité, de sorte que l'élément d'étanchéité de protection de conduction électrique est interposé entre les deux éléments d'étanchéité résistant à la corrosion.

4. Un élément d'étanchéité selon l'une quelconque des revendications précédentes, selon lequel l'élément d'étanchéité résistant à la corrosion est fabriqué à partir d'un matériau élastomère chargé d'un matériau approprié pour fournir, ou pour améliorer les propriétés de résistance à la corrosion particulaire.

5. Un élément d'étanchéité selon l'une quelconque des revendications 1 à 4, selon lequel le matériau élastomère à partir duquel l'élément d'étanchéité de protection de conduction électrique est formé est un matériau élastomère chargé d'une charge conductrice.

6. Un élément d'étanchéité selon l'une quelconque des revendications précédentes, selon lequel le matériau d'étanchéité de protection de conduction électrique comprend un matériau élastomère de base chargé d'une poudre métallique.

7. Un élément d'étanchéité selon la revendication 6, selon lequel le matériau élastomère de base de l'élément d'étanchéité de protection de conduction électrique est un matériau à base de silicone ou à base d'époxy.

8. Un élément d'étanchéité selon l'une quelconque des revendications précédentes, selon lequel l'élément d'etanchéité est formé de façon qu'une section de l'élément ou de chaque élément d'étanchéité résistant à la corrosion chevauche l'élément d'étanchéité de protection de conduction électrique.

9. Une méthode de fabrication d'un élément d'étanchéité selon l'une quelconque des revendications précédentes qui comprend l'impression de l'élément d'étanchéité (2) résistant à la corrosion et de l'élément d'étanchéité (3) de protection de conduction électrique.
